# FASCICULE DE BREVET EUROPEEN

(11) **EP 3 516 726 B1**
(45) Date de publication et mention de la délivrance du brevet: **19.07.2023**
(21) Numéro de dépôt: 17780827.6
(22) Date de dépôt: 18.09.2017
(51) Int. Cl.: H01M 10/052, G02F 1/00, H01L 31/00, H01M 10/0565, H01M 6/40, H01M 10/054, H01M 6/22, H01M 10/04

(54) **PROCÉDÉ DE REALISATION D'UN DISPOSITIF ELECTROCHIMIQUE ET DISPOSITIF ELECTRO-CHIMIQUE**
HERSTELLUNGSVERFAHREN EINER ELEKTROCHEMISCHEN VORRICHTUNG UND ELEKTROCHEMISCHE VORRICHTUNG
MANUFACTURING METHOD OF AN ELECTROCHEMICAL DEVICE AND ELECTROCHEMICAL DEVICE

(30) Priorité: 19.09.2016 FR 1658776
(43) Date de publication de la demande: 31.07.2019
(73) Titulaire: Commissariat à l'Énergie Atomique et aux Énergies Alternatives, 75015 Paris (FR)
(72) Inventeur: BAZIN, Arnaud, 38600 Fontaine (FR); OUKASSI, Sami, 38120 Saint-Egrève (FR)
(74) Mandataire: Brevalex
(86) Numéro de dépôt international: PCT/FR2017/052494
(87) Numéro de publication internationale: WO 2018/051045

(56) Documents cités:
- WO-A1-00/25378
- US-A- 5 426 005
- US-A1- 2015 072 245

## Description

### Domaine technique de l'invention

L'invention est relative à un procédé de fabrication d'un dispositif électrochimique.

L'invention est également relative à un dispositif électrochimique.

### État de la technique

Les microbatteries sont définies comme étant des générateurs électrochimiques formés par un empilement de couches minces qui comporte au moins deux électrodes (positive et négative) séparées par un électrolyte. Ces microbatteries permettent notamment d'adapter les sources d'énergie aux nouvelles applications nomades qui sont proposées régulièrement et qui intègrent des microcircuits électroniques.

De nombreux dispositifs électrochimiques et notamment des batteries utilisent un électrolyte sous forme liquide. Cet électrolyte se compose d'un solvant associé à un sel métallique. Cet électrolyte présente une conductivité élevée, supérieure à 10⁻³S/cm, ce qui le rend particulièrement intéressant. Cependant, les dispositifs utilisant un électrolyte liquide sont soumis à des contraintes de sécurité importantes car le risque de fuite de l'électrolyte est non négligeable.

Il est connu d'utiliser des électrolytes complètement solides qui sont réalisés à base de polymères. Les électrolytes complètement solides utilisent un sel métallique associé à une matrice polymère ou inorganique. Ces électrolytes ne contiennent pas de solvants. Ils sont caractérisés par une bonne tenue mécanique et par une conductivité ionique faible, typiquement inférieure à 10⁻⁶ S/cm. L'électrolyte étant sous forme solide, il n'y a pas de risque de fuite.

Des travaux sont réalisés afin d'améliorer les performances des électrolytes et notamment la conductivité ionique. Un exemple de réalisation est décrit dans le document WO00/38263 qui présente l'utilisation d'un électrolyte solide microporeux. Le film électrolyte poreux est réalisé de différentes manières et un électrolyte liquide est ajouté. L'électrolyte liquide est injecté dans le film poreux. Ce mode de réalisation permet d'améliorer les performances en conductivité ionique au moyen de l'électrolyte liquide en comparaison de l'électrolyte tout solide. Cependant, il apparaît que les performances mécaniques de l'électrolyte microporeux ne sont pas satisfaisantes. Il apparaît également que les problèmes de sécurité liés aux fuites de l'électrolyte liquide sont, en partie, maintenus.

Il est également connu d'utiliser des électrolytes Gels-polymères. Ces électrolytes utilisent une matrice polymère ou inorganique qui est utilisée pour confiner un liquide. Ce liquide est formé par le mélange d'un solvant avec un sel métallique. La matrice polymère apporte les propriétés mécaniques et la phase liquide apporte les propriétés électrochimiques. Un tel électrolyte présente des performances électrochimiques améliorées en comparaison d'un électrolyte tout solide à base de polymères. Cependant, les performances électrochimiques et notamment la conductivité ionique sont moins bonnes que celles d'un électrolyte liquide. Il apparaît également que la mise en oeuvre est plus compliquée.

Des travaux ont été effectués afin d'augmenter la conductivité ionique et plus particulièrement la conductivité ionique à basse température. Le document US 2004/0106236 présente un mode de réalisation où l'électrolyte solide est décomposé en deux couches distinctes ayant des performances mécaniques et électrolytiques différentes.

Une première couche d'électrolyte est située du côté de la cathode et cette couche fournit les performances mécaniques de l'électrolyte. Une deuxième couche d'électrolyte est située du côté de l'anode et cette couche fournit les performances électrolytiques. Cette deuxième couche d'électrolyte assure la transmission des ions lithium entre l'anode et la cathode.

Là encore, il apparaît que les performances en conductivité ionique de la couche d'électrolyte dans sa globalité ne sont pas satisfaisantes.

Le document US 5,426,005 divulgue un électrolyte formé d'un réseau de polymères de natures chimiques différentes. Les polymères peuvent être polymérisés successivement ou simultanément.

Une autre solution a encore été proposée dans le document US 8,420,701. Ce document propose de réaliser une couche d'électrolyte bi-matière. La couche d'électrolyte est formée par un film perforé qui est rempli par une résine échangeuse d'ions. Il apparaît que cette solution ne donne pas satisfaction d'un point de vue de la conduction ionique et de la mise en oeuvre.

### Objet de l'invention

L'invention a comme objet de fournir un procédé de fabrication d'un dispositif électrochimique qui est facile à mettre en oeuvre et qui permet de réaliser un dispositif avec un électrolyte qui est globalement plus performant.

Le procédé de fabrication du dispositif électrochimique est remarquable en ce qu'il comporte les étapes suivantes :
- fournir une première électrode,
- fournir une deuxième électrode,
- fournir un électrolyte isolant électroniquement et conducteur ioniquement, l'électrolyte présentant un taux de réticulation initial et une densité de réticulation initiale, l'électrolyte étant au moins en contact avec la première électrode,
- réaliser une étape de polymérisation de l'électrolyte de manière à définir au moins une première zone de polymérisation présentant un premier taux de réticulation et une première densité de réticulation et une deuxième zone de polymérisation présentant un deuxième taux de réticulation différent du premier taux de réticulation et/ou une deuxième densité de réticulation différente de la première densité de réticulation, les premier et deuxième taux de réticulation étant supérieurs au taux de réticulation initial et les première et deuxième densités de réticulation étant supérieures à la densité de réticulation initiale.

Dans un développement, l'étape de polymérisation définit une alternance de premières zones de polymérisation et de deuxièmes zones de polymérisation selon une direction parallèle à la première face principale de l'électrolyte.

De manière avantageuse, l'étape de polymérisation est une étape de polymérisation par insolation avec au moins un rayonnement électromagnétique.

Préférentiellement, une source de rayonnement électromagnétique est configurée pour émettre une première puissance de rayonnement électromagnétique pour former la première zone de polymérisation et la deuxième zone de polymérisation.

En alternative, la source de rayonnement électromagnétique est configurée pour émettre simultanément une première puissance de rayonnement électromagnétique pour former la première zone de polymérisation et une deuxième puissance de rayonnement électromagnétique différente de la première puissance pour former la deuxième zone de polymérisation.

Il est intéressant de prévoir que l'étape de polymérisation comporte une étape d'insolation à travers un masque présentant au moins deux régions présentant des taux de transmission différents audit au moins un rayonnement électromagnétique pour former lesdites au moins première et deuxième zones de polymérisation.

Dans un mode de réalisation particulier, les au moins deux régions du masque sont configurées pour laisser passer ledit au moins un rayonnement électromagnétique.

Avantageusement, le procédé comporte une unique étape d'insolation configurée pour former lesdites au moins première et deuxième zones de polymérisation.

Dans un mode de réalisation préférentiel, la durée d'insolation par le rayonnement électromagnétique est identique pour former lesdites au moins première et deuxième zones de polymérisation.

Il est intéressant de prévoir que les durées d'insolation par le rayonnement électromagnétique sont différentes pour former lesdites au moins première et deuxième zones de polymérisation.

Dans un autre développement, avant l'étape de polymérisation, l'électrolyte est sous forme liquide et l'étape de polymérisation est configurée pour former au moins une des zones de polymérisation sous forme solide ou de gel et conserver l'autre des zones de polymérisation sous forme liquide.

De manière avantageuse, avant l'étape de polymérisation, l'électrolyte est sous forme liquide et en ce que l'étape de polymérisation est configurée pour former une première zone de polymérisation sous forme solide ou de gel et une deuxième zone de polymérisation sous forme solide ou de gel.

Dans un mode de réalisation préférentiel, le dispositif électrochimique est une batterie ou un dispositif électrochrome et la première électrode comporte :
- un premier substrat de support,
- un premier collecteur de courant recouvrant le premier substrat de support,
- une première couche électrochimiquement active en contact électrique avec le premier collecteur de courant.
   L'électrolyte est en contact avec la première couche électrochimiquement active et la deuxième électrode comporte
- une deuxième couche électrochimiquement active séparée de la première couche électrochimiquement active par l'électrolyte,
- un deuxième collecteur de courant en contact avec la deuxième couche électrochimiquement active, le deuxième collecteur de courant étant séparé du premier collecteur de courant par l'électrolyte,
- un deuxième substrat de support.

Avantageusement, la polymérisation de l'électrolyte est réalisée au moyen d'un rayonnement ultraviolet.

Dans un mode de réalisation préférentiel, la deuxième électrode est mise en contact avec l'électrolyte, avant l'étape de polymérisation.

Dans un autre mode de réalisation, la deuxième électrode est mise en contact avec l'électrolyte, après l'étape de polymérisation

L'invention a également pour objet, un dispositif électrochimique qui est plus performant.

Le dispositif électrochimique est remarquable en ce qu'il comporte une première électrode et une deuxième électrode séparées par un électrolyte électriquement isolant. L'électrolyte comporte une première zone de polymérisation présentant un premier taux de réticulation et une première densité de réticulation et une deuxième zone de polymérisation présentant un deuxième taux de réticulation différent du premier taux de réticulation et/ou une deuxième densité de réticulation différente de la première densité de réticulation. Lesdites au moins première et deuxième zones relient la première électrode avec la deuxième électrode et la première zone de polymérisation et la deuxième zone de polymérisation sont formées par un électrolyte solide contenant un polymère. La première zone de polymérisation est formée par un premier mélange ayant le premier taux de réticulation et la première densité de réticulation et la deuxième zone de polymérisation est formée par le premier mélange ayant le deuxième taux de réticulation et la deuxième densité de réticulation.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 5 représentent, de manière schématique, en coupe, quatre alternatives de réalisation d'un procédé de fabrication d'un dispositif électrochimique,
- les figures 6, 7 et 8, représentent de manière schématique, en vue de dessus, différentes organisation des premières et deuxièmes zones de l'électrolyte sur la première électrode,
- les figures 9, 10 et 11, représentent de manière schématique, en coupe, une autre variante de réalisation d'un procédé de fabrication d'un dispositif électrochimique,
- les figures 12, 13 et 14, représentent de manière schématique, en coupe, un autre mode de réalisation d'un procédé de fabrication d'un dispositif électrochimique,
- la figure 15, représente de manière schématique, en coupe, une alternative de réalisation au procédé de fabrication illustré à la figure 14,
- les figures 16 et 17 illustrent un autre mode de réalisation où les deux électrodes sont formées sur un même substrat de support,
- les figures 18 et 19 illustrent l'évolution de la conductivité ionique et des performances mécaniques en fonction de la puissance d'insolation pour un électrolyte ayant un taux de réticulation égal à 100%.

### Description détaillée

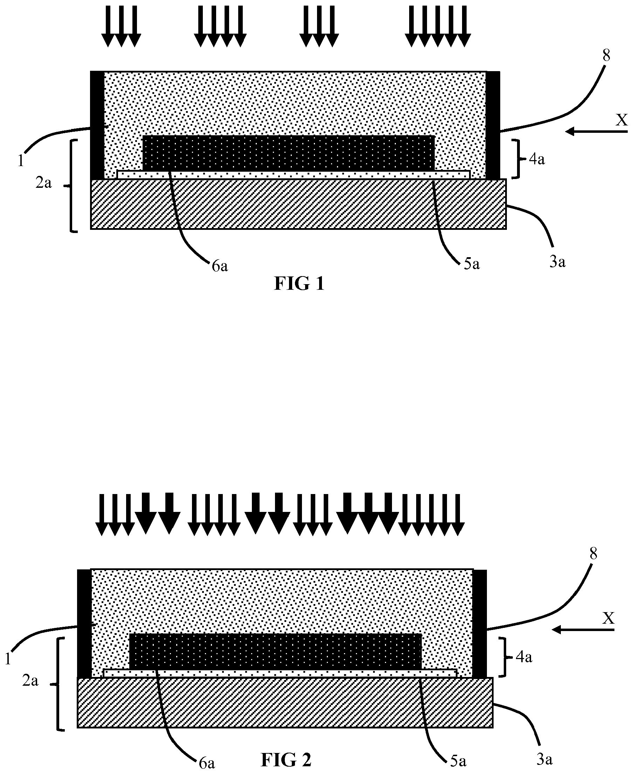

Le procédé comporte la fourniture d'un premier empilement qui comporte une première électrode 2a recouverte par un électrolyte 1 dans le but de former un dispositif électrochimique comme cela est illustré à la figure 1.

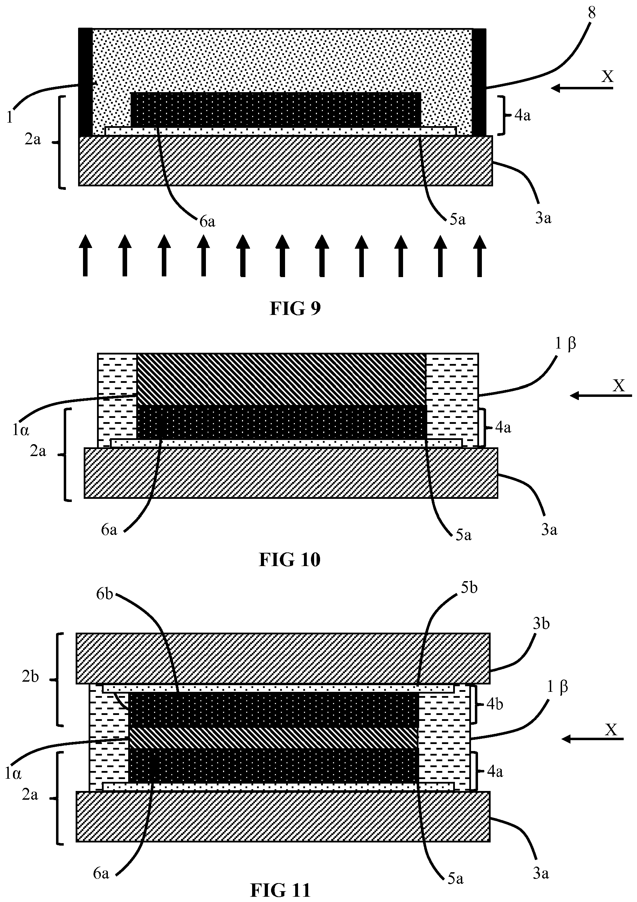

Comme illustré à la figure 11, à titre d'exemple, le dispositif électrochimique comporte un électrolyte 1 qui sépare physiquement et électriquement des première et deuxième électrodes 2a et 2b. Les première et deuxième électrodes 2a et 2b sont distinctes et électriquement conductrices.

Selon les modes de réalisation, le dispositif électrochimique peut être par exemple : une batterie et plus particulièrement une microbatterie, un dispositif électrochrome ou un condensateur et plus particulièrement une supercapacité.

Dans un premier mode réalisation, au moins l'une des première et deuxième électrodes 2a et 2b assure le maintien mécanique du dispositif électrochimique. Dans un mode de réalisation, la première électrode 2a assure la fonction de support et la deuxième électrode 2b sert de capot pour refermer le dispositif électrochimique. Dans une variante de réalisation, la première électrode 2a et la deuxième électrode 2b assurent, toutes les deux, la fonction de support mécanique.

De manière avantageuse, les première et deuxième électrodes 2a et 2b présentent des caractéristiques barrières. De préférence, dans le cas d'une batterie ou d'un dispositif électrochrome, les première et deuxième électrodes 2a et 2b sont une barrière à la diffusion de polluant tels que O₂ ou H₂O dans le dispositif électrochimique.

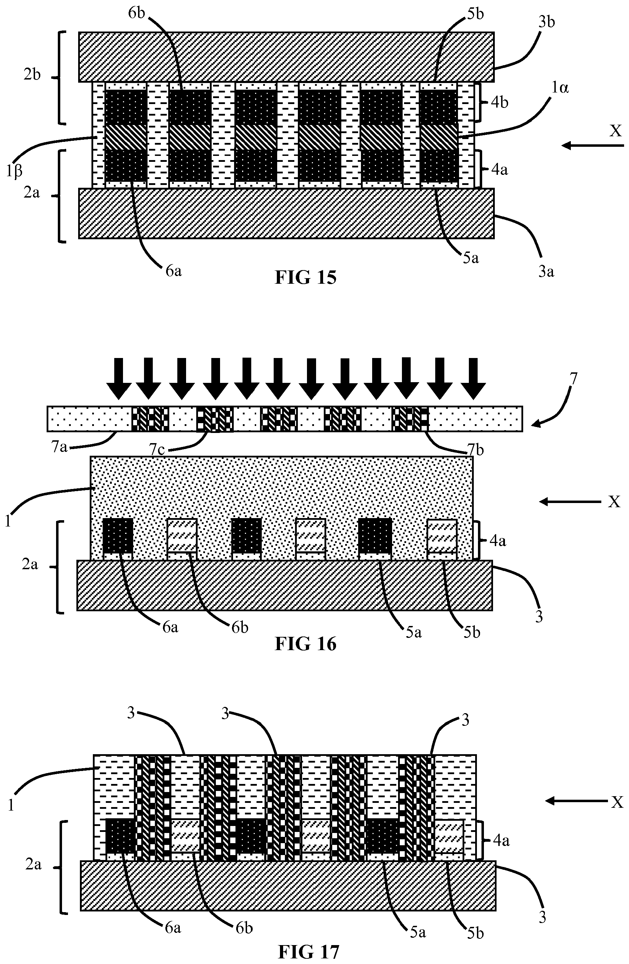

Dans un autre mode de réalisation illustré à la figure 16, la première et la deuxième électrodes 2a et 2b sont formées sur un même substrat de support 3.

Dans un premier mode de réalisation particulier, la première et/ou la deuxième électrodes 2a et 2b sont réalisées exclusivement en matériaux électriquement conducteurs. La première électrode 2a et la deuxième électrode 2b peuvent être réalisées dans des matériaux identiques ou différents. La première électrode 2a et la deuxième électrode 2b peuvent être réalisées intégralement dans un métal. Le métal peut être un élément pur ou un alliage métallique. L'élément pur ou les constituants de l'alliage peuvent être choisis parmi les éléments suivants : aluminium, cuivre, nickel, titane, argent, or, chrome, tungstène, tantale, baryum et platine. Il est également possible de réaliser la première électrode 2a et/ou la deuxième électrode 2b dans un alliage contenant au moins deux des matériaux précédents.

La première électrode 2a et/ou la deuxième électrode 2b peuvent avoir des surfaces principales planes ou tridimensionnelles, c'est-à-dire qui comportent des zones en saillie et/ou des creux. Les surfaces principales planes ou tridimensionnelles sont les deux surfaces en vis-à-vis et en contact avec l'électrolyte 1.

Dans une variante de réalisation illustrée aux figures 1, 2 et 9 à 15, la première et/ou la deuxième électrodes 2a et 2b sont formées par des empilements de plusieurs couches différentes. Ces empilements comportent avantageusement un premier substrat de support 3a et un deuxième substrat de support 3b en matériau électriquement isolant. Le premier substrat de support 3a et le deuxième substrat de support 3b sont respectivement recouverts par une première couche électriquement conductrice 4a et une deuxième couche électriquement conductrice 4b.

Dans un mode de réalisation particulier, le premier substrat de support 3a et/ou le deuxième substrat support 3b peuvent être réalisés dans des matériaux identiques ou différents. Le substrat de support 3a/3b peut être réalisé par exemple en silicium, en verre, en quartz, en mica, en silicates, en matériau céramique et/ou en matériau plastique. Il est, avantageux, de réaliser le substrat de support 3a/3b en matériau plastique choisi parmi le polyimide qui peut être vendu sous la marque Kapton^{®} ou le poly(téréphtalate d'éthylène) qui peut être vendu sous la marque Mylar^{®}.

Dans une alternative de réalisation illustrée aux figures 16 et 17, la première électrode 2a et la deuxième électrode 2b partagent le même substrat de support 3. Le substrat de support 3 est électriquement isolant et peut être réalisé dans les matériaux cités précédemment.

Selon les modes de réalisation, les première et deuxième électrodes 2a et 2b sont en contact avec deux faces principales opposées de la couche d'électrolyte 1 ou elles sont en contact avec une seule des faces principales de la couche d'électrolyte 1.

La première couche électriquement conductrice 4a et/ou la deuxième couche électriquement conductrice 4b peuvent être réalisées dans des matériaux identiques ou différents. La couche électriquement conductrice 4a/4b peut être réalisée dans l'un des matériaux électriquement conducteurs présentés ci-dessus pour former les électrodes 2a/2b.

Dans un mode de réalisation avantageux, la première couche électriquement conductrice 4a et/ou la deuxième couche électriquement conductrice 4b comportent respectivement un premier collecteur de courant 5a recouvert par une première couche électrochimiquement active 6a et un deuxième collecteur de courant 5b recouvert par une deuxième couche électrochimiquement active 6b.

La première couche électrochimiquement active 6a et/ou la deuxième couche électrochimiquement active 6b présentent avantageusement des propriétés électrochimiques communes avec l'électrolyte 1.

Le collecteur de courant 5a/5b est réalisé dans un matériau conducteur du courant électrique. Le collecteur de courant 5a/5b peut être réalisé dans l'un quelconque des différents matériaux proposés pour former les électrodes 2a/2b. Le premier collecteur de courant 5a peut être réalisé dans un matériau identique ou différent de celui du deuxième collecteur de courant 5b. De manière avantageuse, le collecteur de courant est réalisé en métal et comporte au moins 90 % atomique d'un des métaux précédents. Il est également possible de réaliser les collecteurs de courant en alliage métallique à partir d'un ou plusieurs des matériaux précédents.

La première couche électrochimiquement active 6a et la deuxième couche électrochimiquement active 6b peuvent être réalisées dans des matériaux identiques ou différents. Il est avantageux d'utiliser la première couche électrochimiquement active 6a et/ou la deuxième couche électrochimiquement active 6b pour former une batterie ou un dispositif électrochrome.

La première couche électrochimiquement active 6a ou la deuxième couche électrochimiquement active 6b forme une électrode positive. L'électrode positive est à insertion cationique pour insérer par exemple Na⁺ ou Li⁺. Pour former l'électrode positive, il est possible d'utiliser les matériaux d'intercalation du lithium et par exemple ceux du groupe LiMO et plus particulièrement : LiCoO₂, LiFeO₂, LiNiO₂, LiMn₂O₄, Li_{0,33}MnO₂ et plus généralement les matériaux de type LiMₓMn₂₋ₓO₄ avec 0≤x≤0,5 et M=Ni, Co, Fe, Ti.... Il est encore possible de réaliser l'électrode positive dans un matériau choisi parmi LiCoPO₄, LiFePO₄, Li₄Ti₅O₁₂, LiTiOS.

Il peut en être de même pour le sodium et d'une manière générale pour l'ion utilisé dans le fonctionnement du dispositif électrochrome ou de la batterie.

L'autre couche électrochimique active 6b ou 6a est une électrode négative. Le matériau utilisé pour former l'électrode négative dépend du type de batterie considérée, c'est-à-dire du type d'électrolyte 1 utilisé. La batterie peut être de type lithium métallique avec une électrode en lithium métallique.

L'électrode négative peut également être de type lithium-ion avec des matériaux capables de former un alliage ou un composé défini avec le lithium. Les matériaux formant la couche électrochimiquement active 6a/6b sont avantageusement choisis dans la liste constituée par : Bi, Sb, Si, Sn, Zn, Ni, Cd, Ce, Co, Fe, Mg, Ge. Il est également possible de choisir des oxydes de type MₓO_{y} ou des sulfures de type MₓS_{y} avec M représentant un métal. Il est encore possible de réaliser l'électrode au moyen d'un complexe de type MF ou MF2 avec M représentant un métal et F représentant le fluor.

Il est encore possible de réaliser une batterie de type « lithium-free ». Dans ce cas, l'une des couches électrochimiquement actives 6a ou 6b est présente. L'électrode négative peut être réalisée dans un matériau non électrochimiquement actif, par exemple dans un matériau apte à former un collecteur de courant, par exemple en cuivre. Il peut en être de même pour les batteries à base de sodium.

Ce mode de réalisation est particulièrement avantageux lorsque les premier et/ou deuxième collecteurs de courant 5a et 5b sont dépourvus de propriété électrochimique et/ou ne sont pas électrochimiquement actifs et encore plus avantageusement lorsque les premier et/ou deuxième collecteurs de courant 5a et 5b présentent une meilleure conductivité électrique que les première ou deuxième couches électrochimiquement actives 6a ou 6b.

En alternative, il est également possible de réaliser la couche électriquement conductrice 4a/4b dans un matériau présentant des propriétés électrochimiques et/ou étant électrochimiquement actif et choisi parmi les matériaux présentés ci-dessus pour former les couches 6a/6b.

Ces propriétés sont particulièrement recherchées pour la formation d'une microbatterie et d'un dispositif électrochrome.

Comme indiqué plus haut, la couche d'électrolyte 1 sépare les deux électrodes 2a et 2b et plus précisément, la couche d'électrolyte 1 sépare les premier et deuxième substrats de support 3a et 3b ainsi que les première et deuxième couches électriquement conductrices 4a et 4b.

Dans certains modes de réalisation, il est également prévu que la couche d'électrolyte 1 sépare les premier et deuxième collecteurs de courant 5a et 5b ainsi que les première et deuxième couches électrochimiquement actives 6a et 6b.

Afin de réaliser un dispositif électrochimique plus robuste, il est particulièrement avantageux d'utiliser un électrolyte 1 qui est au moins en partie sous forme de solide ou de gel ce qui permet de limiter les risques de fuite. Cependant, l'utilisation d'un électrolyte sous forme de solide ou de gel se traduit généralement par la réalisation d'un procédé de fabrication plus complexe et des problèmes d'interfaces, principalement entre les électrodes 2a et/ou 2b et l'électrolyte 1.

Afin d'assurer un bon contact entre les électrodes 2a et 2b, l'électrolyte 1 est initialement sous forme de liquide ou de gel ce qui permet de s'adapter aux différentes morphologies de la surface de l'électrode 2a/2b. Lorsque l'électrode comporte des vides et/ou un matériau poreux, l'utilisation d'un électrolyte liquide ou sous la forme d'un gel peu visqueux permet de pénétrer dans les vides par exemple les pores de l'électrode. Cela permet d'assurer une bonne imprégnation de chacune des électrodes avec l'électrolyte 1. Cette configuration est particulièrement avantageuse lorsqu'au moins une des électrodes 2a/2b est tridimensionnelle, c'est-à-dire qu'elle comporte un élément en saillie. L'électrolyte peut alors s'infiltrer facilement dans les tortuosités du matériau ce qui n'est pas le cas avec un électrolyte solide ou très visqueux.

L'électrolyte 1 est configuré pour pouvoir être polymérisé et ainsi augmenter son taux de réticulation et/ou sa densité de réticulation. L'électrolyte 1 peut se transformer en un électrolyte solide ou un gel. Avant l'étape de polymérisation , l'électrolyte 1 présente un taux de réticulation initial et une densité de réticulation initiale. Comme indiqué plus haut, lors de l'étape de polymérisation, les première et deuxième électrodes 2a et 2b sont en contact avec l'électrolyte 1. En alternative, la première électrode est en contact avec l'électrolyte 1, lors de la polymérisation, et la deuxième électrode 2b est mise en contact avec l'électrolyte 1 plus tard.

Une étape de polymérisation est réalisée alors que l'électrolyte 1 est en contact avec la première électrode 2a. De cette manière, l'électrolyte polymérisé restera parfaitement en contact avec l'électrode 2a. Ce mode de réalisation est préférable à un mode de réalisation où l'électrolyte est déjà réticulé avant sa connexion avec la première électrode 2a. L'électrolyte étant malléable, il peut se déformer pour compenser en partie les aléas de fabrication et assurer un contact parfait avec la première électrode 2a avant sa polymérisation.

Cette solution est particulièrement avantageuse lors de la réalisation d'une batterie ou d'un dispositif électrochimique qui comporte un collecteur de courant qui est surmonté par une couche électrochimiquement active. Les différentes couches formées définissent des motifs tridimensionnels. Par exemple, le sommet et les faces latérales sont en contact intime avec l'électrolyte avant et après polymérisation ce qui améliore les performances électriques en augmentant la surface de contact entre l'électrolyte 1 et l'électrode 2a.

Un électrolyte sous forme liquide est un électrolyte qui est capable de couler, qui présente une faible cohésion entre ses molécules et qui est facilement déformable.

Un électrolyte sous forme de gel est un électrolyte qui ne coule pas mais qui reste déformable.

Un électrolyte sous forme solide est un électrolyte qui ne coule pas et qui ne peut pas se déformer sans casser. Il présente une forte cohésion entre ses molécules.

La transformation en un électrolyte plus rigide par exemple un électrolyte solide ou sous la forme d'un gel par polymérisation peut être obtenue de différentes manières.

Il est avantageux d'utiliser un rayonnement électromagnétique pour transformer l'électrolyte 1 en un électrolyte plus rigide. En effet, cela évite de chauffer le dispositif électrochimique ce qui peut entraîner la dégradation de certains de ces constituants. Cela évite également la formation d'un dispositif électrochimique qui est perméable au solvant car ce mode de réalisation peut être compliqué à mettre en oeuvre dans le choix des matériaux.

L'électrolyte 1 est configuré pour être un isolant électronique et préférentiellement un conducteur ionique sous sa forme solide ou de gel. L'électrolyte est avantageusement configuré pour être un isolant électronique et préférentiellement un conducteur ionique sous sa forme liquide.

L'électrolyte 1 est avantageusement formé d'une matrice polymère ou inorganique qui lui confère ses propriétés structurelles et d'un liquide qui lui apporte ses propriétés électriques et électrochimiques.

De manière avantageuse, la matrice est formée par un matériau poreux. Les pores de la matrice sont remplis par une solution liquide comprenant au moins un sel de l'ion à déplacer entre les électrodes. L'ion utilisé peut être par exemple le lithium ou le sodium selon le type de batterie désirée. En variante, il est également possible de prévoir que l'ion peut être choisi parmi le potassium, l'argent, le cuivre, le magnésium et l'aluminium.

En alternative ou en association, l'électrolyte 1 est formé par le mélange des différents composants. Lors de l'étape de polymérisation, le liquide ionique et/ou le sel de l'ion sont emprisonnés.

L'électrolyte contient avantageusement une matrice et par exemple une matrice polymère qui peut être formée par un matériau choisi parmi le Polyéthylène glycol (PEO), le diméthacrylate de bisphénol A éthoxylé (BEMA, bisphenol A ethoxylate dimethacrylate), le poly (éthylène glycol) diacrylate, le méthyl méthacrylate, le polyfluorure de vinylidène (PVDF), le polyméthacrylate de méthyle (PMMA), le polyacrylonitrile (PAN), le polyfluorure de vinylidène - hexafluoropropylène (PVDF-HFP, poly(vinylidene fluoride-co-hexafluoropropylene)).

Pour former la matrice, il est encore possible d'utiliser un poly(liquide ionique). A titre d'exemple, il est avantageux d'utiliser le (poly(N-vinylimidazolium)bis(trifluoromethanesulfonylamide)).

Il est encore possible d'utiliser une matrice inorganique de type silice qui est avantageusement choisie parmi l'orthosilicate de tétraéthyle (TEOS), le méthyltriméthoxysilane (NTMS, methyltrimethoxysilane), l'orthosilicate de tétraméthyle (TMOS), le triéthoxyvinylsilane (TEVOS) ou encore un mélange de ces derniers.

L'électrolyte 1 peut également contenir un solvant et avantageusement un solvant carbonate et plus avantageusement un solvant choisi parmi le carbonate d'éthylène (EC), le carbonate de propylène (PC), le carbonate de diéthyle (DEC), le carbonate de diméthyle (DMC), le succinonitrile (SN) le glutaronitrile (GN), le vinyl carbonate (VC). L'électrolyte 1 peut également contenir un mélange de plusieurs des solvants précédents.

L'électrolyte 1 peut également contenir un liquide ionique qui est préférentiellement choisi dans les liquides ioniques de la famille des anions piperidinium, imidazolium, pyrrolidinium, pyridinium ou des anions ammonium. Ces liquides ioniques sont avantageusement associés à l'un au moins des cations de type acétate CH3COO-, bis(trifluoromethanesulfonyl)imide TFSI-, bis(fluorosulfonyl)imide FSI-, bis(oxalate)borate B(O4C2)2-, bromure Br-, chlorure Cl-, iodure I-, tetrachloroaluminate Cl- :AlCl2, hexafluorophosphate PF6-, tetrafluoroborate BF4-, dicyanamide N(CN)2-, éthylphosphonate (C2H5O)(H)PO2-, methylphosphonate (CH3O)(H)PO2-, sulfate d'hydrogène HSO4-, methanesulfonate CH3SO3-, et/ou trifluoromethanesulfonate CF3SO3-. L'électrolyte 1 peut également contenir un mélange de plusieurs des liquides ioniques précédents avec un ou plusieurs des cations précédents.

En variante, il est encore possible de former un électrolyte 1 qui contient au moins un des solvants précédents et au moins un des liquides ioniques précédents.

Il est avantageux d'utiliser un liquide ionique choisi parmi le PYR13TFSI ou N-Propyl-N-methylpyrrolidinium bis(trifluoromethanesulfonyl)imide, le PYR14TFSI ou 1-Butyl-1-methylpyrrolidinium bis(trifluoromethanesulfonyl)imide, le EMITFSI ou 1-ethyl-3-methylimidazolium-bis (trifluoromethyl-sulfnyl)imide, le BMITFSI ou 1-butyl-3-methylimidazolium bis(trifluoromethylsulfonyl)imide et le EMIPFSI ou 1-Ethyl-3-methylimidazolium bis(perfluoroethylsulfonyl)imide.

En variante, il est encore possible de former un électrolyte 1 qui contient au moins un des solvants précédents et au moins un des liquides ioniques précédents.

Pour former une batterie au lithium, l'électrolyte 1 contient avantageusement un sel de lithium choisi parmi le chlorure de lithium (LiCI), le bromure de lithium (LiBr), l'iodure de lithium (Lil), le perchlorate de lithium (LiClO₄, Lithium perchlorate), le lithium hexafluorophosphate (LiPF₆, Lithium hexafluorophosphate), le lithium bis(fluorosulfonyl)imide (LiFSI), le tétrafluoroborate de lithium (LiBF₄, Lithium tetrafluoroborate), l'hexafluoroarsénate de lithium (LiAsF₆, Lithium hexafluoro arsenate), le Lithium trifluoromethanesulfonate (LiCF3SO3), le lithium bis(trifluoromethanesulfonyl)imide (LiTFSI, (Bis(trifluoromethane)sulfonimide lithium), le Lithium bis(trifluoromethanesulfonyl)imide (LiN(CF3SO2)2, ou un mélange de plusieurs de ces sels entre eux.

De la même manière, pour former une batterie au sodium, l'électrolyte 1 contient un sel de sodium. Il est encore possible de prévoir que la batterie ou le dispositif électrochrome comporte un sel d'un autre des ions présentés plus haut.

Pour réaliser la polymérisation au moyen d'un rayonnement électromagnétique et plus particulièrement au moyen d'un rayonnement ultraviolet, il est avantageux d'ajouter un photo-initiateur à l'électrolyte 1. Le photo-initiateur est avantageusement choisi parmi le 2-hydroxy-2-methyl-1-1-phenylpopane-1-one (commercialisé sous le nom Darocur^{™} 1173 ou HMPP), l'azobisisobutyronitrile (AIBN), le 2-2-dimethoxy-2-phenylacetophenone (DMPA), le benzophenone (BP), le p-xylène-bis(n,n-diethyldithiocarbonate) (XDT).

En choisissant judicieusement les constituants de l'électrolyte 1 et notamment le photo-initiateur, il est possible de définir la longueur d'onde du rayonnement qui permet de polymériser l'électrolyte 1.

À titre d'exemple, un électrolyte 1 contenant une matrice polymère de type BEMA et un photo-initiateur de type HMPP est réactif à une longueur d'onde égale à 365 nm. Il est avantageux d'utiliser une puissance de rayonnement comprise entre 3 et 40 mW/cm² et une dose qui peut varier entre 0,2 et 0,5mWh/cm² pour réaliser la polymérisation. L'homme du métier gardera à l'esprit que la dose et la puissance d'insolation peuvent varier afin de tenir compte des paramètres physico-chimiques recherchés et notamment pour obtenir des propriétés mécaniques, électrochimiques et chimiques spécifiques.

Dans un mode de réalisation, l'étape de polymérisation est une étape de polymérisation au moins partielle de l'électrolyte 1 par insolation de l'électrolyte 1 au moyen d'un premier rayonnement électromagnétique à travers la première et/ou la deuxième électrode 2a/2b. Le dispositif est soumis à une étape de polymérisation de l'électrolyte 1. L'électrolyte 1 va donc réagir pour se transformer au moins en partie en un électrolyte plus rigide, par exemple en un électrolyte solide ou sous forme de gel.

Comme illustré aux figures 1 à 5, le premier empilement est soumis à une étape de polymérisation de l'électrolyte 1 qui est configurée pour former une première zone 1α et une deuxième zone 1β. La première zone 1α est distincte de la deuxième zone 1β. L'électrolyte 1 va réagir pour se transformer au moins partiellement en un électrolyte plus rigide, par exemple en un électrolyte solide. La différence de rigidité peut se traduire par une augmentation de du module de Young.

Selon les modes de réalisation, l'étape de polymérisation est réalisée avant que la deuxième électrode 2b soit en contact avec l'électrolyte 1. En alternative, les première et deuxième électrodes 2a et 2b sont en contact avec l'électrolyte 1 lors de l'étape de polymérisation.

Dans un mode de réalisation préférentiel, la source de rayonnement électromagnétique émet une première puissance de rayonnement électromagnétique pour former la première zone 1α et la deuxième zone 1β.

Avant l'étape de polymérisation, l'électrolyte 1 est formé par un premier mélange comportant des monomères et/ou des pré-polymères. Après l'étape de polymérisation, l'électrolyte est formé par le premier mélange dans lequel les monomères et/ou pré-polymères ont réagi pour former des polymères. La composition chimique est donc la même à l'exception de la réaction de polymérisation des monomères et/ou pré-polymères. La composition chimique est la même dans la première zone 1α et la deuxième zone 1β à l'exception de la réaction de polymérisation des monomères qui est différente.

La première zone 1α est formée par matériau ayant un premier taux de réticulation et/ou une première densité de la réticulation. La deuxième zone 1β est formée par un matériau ayant un deuxième taux de réticulation et/ou une deuxième densité de réticulation. Le deuxième taux de réticulation est différent du premier taux de réticulation et/ou la deuxième densité de réticulation est différente de la première densité de réticulation.

Les deux zones 1α/1β sont formées par le même matériau qui se trouve à des niveaux différents de la réaction de polymérisation ou dans des états différents de réticulation. Ces différences de réticulation entraînent des différences dans les propriétés électrochimiques et notamment des différences de conductivité ionique. Cette différence de niveau de réticulation entraîne également des différences dans les propriétés mécaniques. De manière avantageuse, les première et deuxième zones présentent des taux de réticulation et/ou des densités de réticulation qui sont différentes du taux de réticulation initial et/ou de la densité de réticulation initiale.

La densité de réticulation représente le nombre de ponts qui sont présents dans le réseau polymère, cela correspond au nombre de liaisons par motif constitutif du matériau polymère. Le taux de réticulation correspond au taux d'avancement de la réaction également appelé taux de conversion et il représente le rapport entre le nombre d'espèces ayant réagi et le nombre initial d'espèces disponibles pour la réticulation.

Selon les modes de réalisation, avant l'étape de polymérisation, l'électrolyte 1 peut être sous forme liquide ou sous forme de gel. Après polymérisation, l'électrolyte peut être sous forme solide ou il peut être utilisé sous la forme d'un gel. L'électrolyte est formé d'une matrice polymère ou inorganique qui lui confère ses propriétés structurelles et d'un matériau actif par exemple sous forme de gel ou sous forme solide qui lui apporte ses propriétés électriques et électrochimiques.

L'étape de polymérisation est une étape de polymérisation au moins partielle de l'électrolyte de manière à former la première zone 1α et la deuxième zone 1β.

L'étape de polymérisation est avantageusement une étape de polymérisation par insolation avec au moins un rayonnement électromagnétique. L'utilisation d'une polymérisation par insolation est particulièrement avantageuse car elle permet de définir précisément et facilement les contours des première et deuxième zones 1α/1β dans la couche d'électrolyte 1.

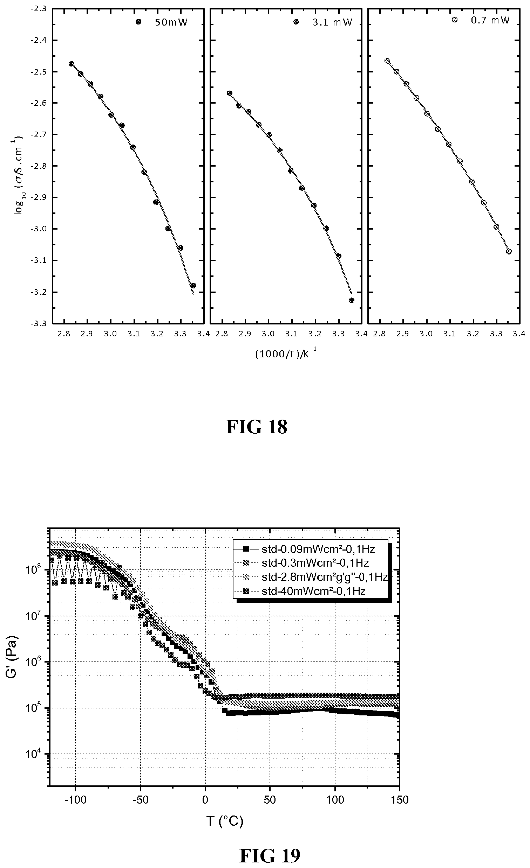

La figure 18 illustre l'influence de la puissance d'insolation sur la conductivité ionique de l'électrolyte. On peut s'apercevoir qu'utiliser deux puissances différentes permet l'obtention de deux électrolytes avec des conductivités ioniques différentes. Le taux de réticulation est identique entre les trois échantillons et égal à 100%. Ces résultats sont obtenus par spectrométrie d'impédance électrochimique. L'électrolyte contient un polymère, ici le BEMA, un liquide ionique le Pyr13TFSI, et un sel de lithium le LiTFSI. L'électrolyte contient 30% en masse de polymère et 70% en masse du mélange formé par le liquide ionique et le sel de lithium. La concentration en LiTFSI dans le mélange Pyr13TFSI/ LiTFSI est égale à 0,231 molaire, c'est-à-dire 0,231 mol/L. L'électrolyte contient également un photo-initiateur qui est ici le Darocur 1173 commercialisé par la société Ciba.

La figure 19 illustre l'influence de la puissance d'insolation sur le comportement mécanique de l'électrolyte et plus particulièrement sur la valeur du plateau caoutchoutique. Ces résultats sont obtenus par analyse mécanique dynamique AMD. Il apparaît que les échantillons soumis aux puissances les plus importantes présentent un module complexe de Coulomb plus élevé qui est représentatif d'une rigidité plus importante. L'électrolyte est identique à celui présenté dans la figure 18.

De manière avantageuse, les première et deuxième zones 1α/1β relient, toutes les deux, la première face principale de la couche d'électrolyte 1 avec l'autre face principale opposée de la couche d'électrolyte 1. L'une des faces principales est en contact avec la première électrode 2a. De cette manière, la couche d'électrolyte 1 définit des canaux privilégiés de circulation des ions entre les deux faces principales et donc entre les deux électrodes 2a et 2b.

Dans un premier mode de réalisation, lors de l'étape de polymérisation, tout le volume d'électrolyte 1 se transforme, c'est-à-dire que tout le volume d'électrolyte change d'état. Il est avantageux de transformer un électrolyte liquide en un électrolyte solide afin d'éliminer les risques de fuite. Il est également avantageux de transformer une partie de l'électrolyte liquide en un électrolyte sous forme de gel pour réduire les risques de fuite et faciliter l'insertion de la deuxième électrode 2b. L'autre partie de l'électrolyte est sous la forme d'un solide ou d'un gel.

Le rayonnement utilisé permet avantageusement de polymériser l'électrolyte liquide 1 et de remplacer l'interface entre la première électrode 2a et électrolyte liquide 1 par une interface entre la première électrode 2a et l'électrolyte solide ou sous forme de gel.

Dans un autre mode de réalisation, l'étape de polymérisation est une étape de polymérisation au moins partielle de l'électrolyte 1 par insolation de l'électrolyte 1 au moyen d'un premier rayonnement électromagnétique. Seulement une partie du volume de l'électrolyte 1 est transformé. Des canaux en électrolyte relient les deux électrodes pour favoriser les performances ioniques et d'autres canaux sous la forme de gel ou d'un solide connectent les deux électrodes pour assurer un maintien mécanique.

Dans un mode de réalisation avantageux illustré aux figures 1 à 17, l'étape d'insolation est configurée pour appliquer des conditions d'insolation différentes, c'est-à-dire deux puissances de rayonnement différentes et/ou deux doses différentes sur deux zones distinctes de l'électrolyte 1. Ces deux conditions d'insolation différentes vont entraîner deux réactions différentes de polymérisation sur l'électrolyte 1 ce qui va former une première zone 1α et une deuxième zone 1β qui présentent des caractéristiques différentes de réticulation. Ces différences de réticulation se traduisent par des différences de comportement mécanique et de conductivité ionique. La structure du polymère est différente entre la première zone 1α et la deuxième zone 1β.

Dans un premier mode de réalisation illustré aux figures 1 et 2, le rayonnement incident est à puissance variable et provient d'une source de rayonnement électromagnétique qui est configurée pour émettre simultanément des première et deuxième puissances différentes en direction de deux zones du premier empilement. Ces différences de puissance permettent de réticuler l'électrolyte 1 et de former la première zone 1α et/ou la deuxième zone 1β sous la forme de gel ou sous forme solide. Dans le mode de réalisation de la figure 1, la source de rayonnement définit des zones insolées et des zones dépourvues d'insolation. Dans la zone dépourvue d'insolation, l'électrolyte reste dans son état initial. Dans le mode de réalisation de la figure 2, la source de rayonnement définit des zones insolées par une première puissance et des zones insolées par une deuxième puissance différente de la première puissance.

Dans un mode de réalisation particulier, la source de rayonnement électromagnétique peut être formée par des première et deuxième sources élémentaires qui émettent la même puissance ou des puissances différentes.

La source de rayonnement électromagnétique émet avantageusement la même puissance en direction des différentes parties du premier empilement et le rayonnement électromagnétique est absorbé pour définir les première et deuxième zones 1α/1β avec des niveaux de réticulation différents.

Dans un deuxième mode de réalisation qui peut être combiné avec le précédent, il est possible d'utiliser un masque présentant au moins deux régions qui possèdent des taux de transmission différents du rayonnement électromagnétique. Ces différences dans les taux de transmission sont utilisées pour former les première et deuxième zones 1α et 1β de l'électrolyte 1. Ce mode de réalisation est particulièrement avantageux, il permet de changer rapidement la forme des zones en changeant uniquement la forme des première et deuxième régions du masque. De manière avantageuse, le taux de transmission est compris entre 1% et 100% de transmission. Les première et deuxième zones 1α/1β en électrolyte sont définies par la forme des première et deuxième régions en relation avec la direction du rayonnement incident à travers le masque.

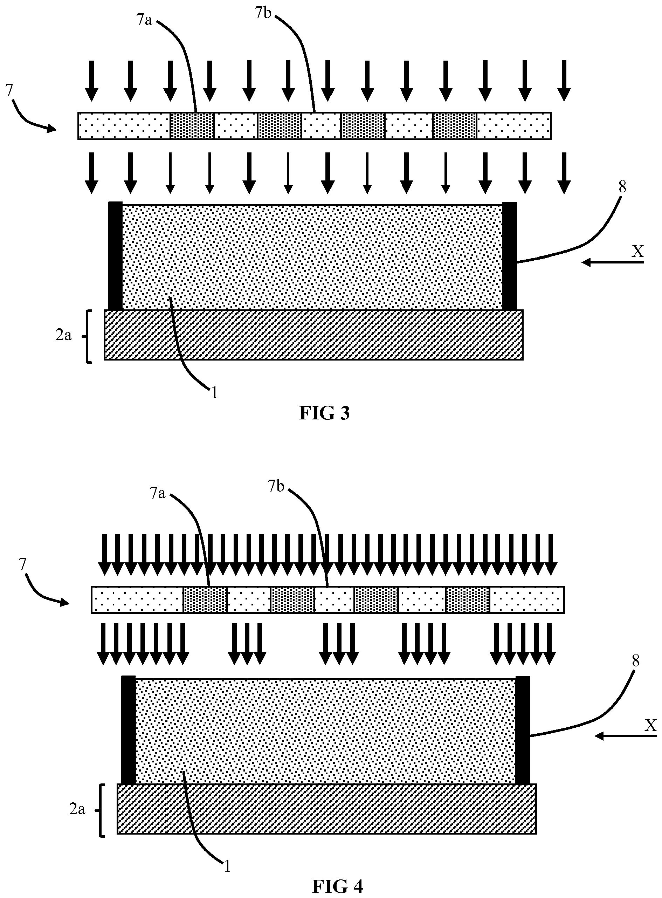

Dans un premier cas de figure illustré aux figures 3 et 4, le masque est un masque externe 7 qui est distinct de la première électrode 2a et plus préférentiellement du dispositif électrochimique. Le masque 7 est utilisé pour former la première zone 1α et la deuxième zone 1β. La figure 3 illustre deux régions 7a et 7b avec des taux de transmission différents et la figure 4 illustre un cas particulier avec des régions opaques et des régions transparentes.

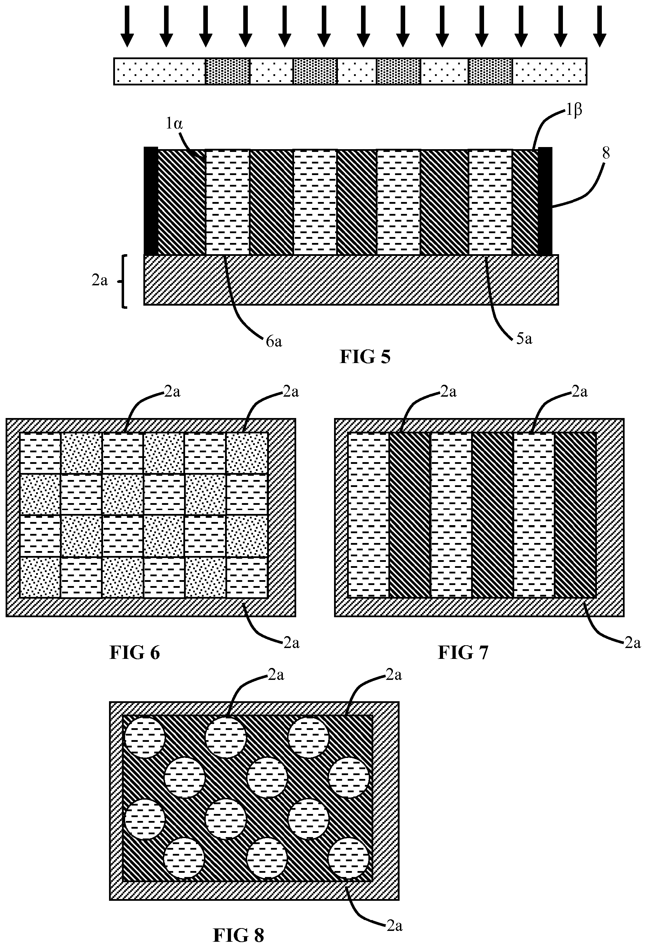

La figure 5 illustre la formation de la première zone 1α et de la deuxième zone 1β dans l'électrolyte 1 après l'étape de polymérisation.

Dans le mode de réalisation illustré à la figure 6, le masque 7 est configuré pour définir un damier de premières zones 1α et de deuxièmes zones 1β.

Dans le mode de réalisation illustré à la figure 7, le masque 7 est configuré pour définir une alternance de bandes de premières zones 1α et de deuxièmes zones 1β. L'alternance est observée selon une direction parallèle à la première face principale de l'électrolyte 1. Les première et deuxième zones sont orientées perpendiculairement à la première face principale pour relier les deux faces principales opposées de l'électrolyte.

Dans le mode de réalisation illustré à la figure 8, le masque 7 est configuré pour définir une pluralité de premières zones 1α sous la forme de piliers à l'intérieur d'une deuxième zone 1β agissant en tant que matrice. Dans l'exemple illustré, les piliers présentent une section circulaire, mais il est également possible de former des piliers avec une section carrée, rectangulaire ou de forme quelconque.

En alternative, il est également possible d'intervertir la première zone 1α avec la deuxième zone 1β.

Il est encore possible de prévoir un masque qui permet de définir une combinaison des différents modes de réalisation.

Dans un deuxième cas de figure illustré aux figures 9 à 15, le masque est un masque interne qui fait partie du premier empilement. Le masque peut être formé dans la première électrode 2a. Le masque est utilisé pour former la première zone 1α et la deuxième zone 1β. Il est particulièrement avantageux de former le masque dans la première électrode 2a car les première et deuxième zones 1α et 1β sont autoalignées par rapport aux motifs de l'électrode 2a ce qui facilite la localisation de zones à performances mécaniques améliorées et de zones à performances ioniques améliorées. Le masque interne peut définir les mêmes motifs en première et deuxième zones 1α et 1β que le masque externe 7 (figures 6 à 8).

Dans un troisième mode de réalisation qui peut être combiné avec les modes précédents, il est possible d'utiliser des durées d'exposition différentes pour former la première zone 1α et la deuxième zone 1β. En alternative, la durée d'insolation par le rayonnement électromagnétique est identique pour former les première et deuxième zones 1α/1β.

Pour modifier la durée d'insolation, il est possible d'utiliser un masque interne ou externe présentant au moins deux régions. Au bout d'une durée prédéterminée, une des régions bloque le rayonnement électromagnétique alors que l'autre région laisse passer le rayonnement électromagnétique. Il est également possible d'utiliser une source de rayonnement qui est configurée pour ne plus émettre dans une région prédéfinie après un temps prédéterminé.

Dans un mode particulier de réalisation qui peut être combiné avec les modes de réalisation précédents, l'étape de polymérisation est configurée pour ne pas insoler la première zone 1α et insoler la deuxième zone 1β de l'électrolyte. La réticulation va avoir lieu dans la deuxième zone 1β et pas dans la première zone 1α. Une configuration inverse est possible.

Dans un mode de réalisation qui peut être illustré aux figures 4 et 9 à 15, le masque est partiellement transparent au rayonnement électromagnétique, c'est-à-dire qu'il possède des régions opaques et des régions transparentes au rayonnement électromagnétique. Dans un cas de figure, toutes les régions transparentes possèdent le même taux de transmission. Dans une alternative, plusieurs taux de transmissions différents peuvent être présents parmi les différentes régions transparentes.

Dans un mode alternatif de réalisation, l'étape de polymérisation est configurée pour insoler la première zone 1α et insoler la deuxième zone 1β de l'électrolyte simultanément. La réticulation va avoir lieu dans la deuxième zone 1β et dans la première zone 1α. Les conditions d'insolation de la première zone 1α sont différentes des conditions d'insolation de la deuxième zone 1β et notamment à cause des différences de taux de transmission et/ou des durées d'insolation.

Dans un autre mode de réalisation qui peut être également illustré aux figures 3 et 9 à 15, le masque est transparent au rayonnement électromagnétique, c'est-à-dire qu'il possède au moins des première et deuxième régions transparentes au rayonnement électromagnétique. Ces première et deuxième régions transparentes présentent des taux de transmission différents.

Dans un mode de réalisation particulier illustré aux figures 3 à 5 et 9 à 15, le masque présente une alternance de premières régions et de deuxièmes régions selon une direction X parallèle à la première surface principale de l'électrolyte et/ou de la première électrode 2a et/ou de la deuxième électrode 2b.

Dans le mode de réalisation illustré aux figures 9 à 15, la région centrale du masque présente un taux de transmission plus faible que la région périphérique car elle est plus épaisse et/ou elle est formée dans un matériau plus absorbant. Par exemple, la région centrale est opaque.

L'étape d'insolation vient définir la première zone 1α et la deuxième zone 1β. De manière avantageuse, la deuxième zone 1β entoure complètement la première zone 1α dans un plan de coupe parallèle à la première face principale de l'électrolyte 1. De cette manière, si la première zone 1α est liquide, les risques de fuite de l'électrolyte liquide sont réduits sans que cela dégrade les performances électrochimiques du dispositif.

Une configuration avec des régions opaques et des régions transparentes peut être utilisée pour transformer partiellement l'électrolyte liquide 1 en un électrolyte solide. Le dispositif comporte alors un électrolyte biphasé. La portion d'électrolyte liquide 1 qui a été transformée en électrolyte solide ou gel permet de réduire les risques de fuite de l'électrolyte liquide 1. Des zones en électrolyte liquide sont conservées pour améliorer les performances ioniques de l'électrolyte 1.

Dans un mode de réalisation, l'étape de polymérisation est configurée pour former partiellement un électrolyte solide. Cet électrolyte solide forme un capot additionnel séparant complètement l'électrolyte liquide 1 et la première électrode 2a. De cette manière, un matériau supplémentaire sépare l'électrolyte liquide 1 de l'extérieur du dispositif ce qui réduit les risques de fuite.

Il est avantageux de prévoir qu'un électrolyte solide est polymérisé sur les zones périphériques en contact avec la première électrode 2a et avec la future deuxième électrode 2b ce qui permet de diminuer les risques de fuite d'un électrolyte liquide 1.

Comme indiquer plus haut, les différentes variantes de réalisation peuvent être utilisées seules ou en combinaison pour former les première et deuxième zones 1α et 1β. Il est possible d'utiliser un masque externe seul ou en association avec un masque interne et éventuellement une source de rayonnement délivrant des puissances différentes simultanément. Il est encore possible d'utiliser un masque interne seul ou en association avec un masque externe et éventuellement une source de rayonnement délivrant des puissances différentes simultanément. Il est encore possible d'utiliser une source de rayonnement délivrant des puissances différentes simultanément seule ou en association avec un masque externe et/ou un masque interne.

Dans un mode de réalisation particulier, les différences de propriétés optiques de la première électrode 2a sont définies en réalisant une première électrode qui utilise des matériaux différents et/ou des épaisseurs différentes de matériaux. Les première et deuxième régions du masque sont avantageusement définies au moyen des différences d'épaisseur de la couche électrochimiquement active 6a et/ou du premier collecteur de courant 5a.

Dans un premier mode de réalisation, la première électrode 2a est formée par un premier substrat de support 3a recouvert successivement par un premier collecteur de courant 5a et par une première couche électrochimiquement active 6a.

La couche électrochimiquement active 6a peut présenter des zones avec des épaisseurs différentes afin de définir des premières régions et des deuxièmes régions dans la première électrode 2a. En variante, la couche électrochimiquement active 6a peut-être gravée afin de définir des zones couvertes et des zones non recouvertes à la surface du collecteur de courant 5a et ainsi définir des premières régions et des deuxièmes régions dans la première électrode 2a et donc dans le masque interne. Il est particulièrement avantageux de prévoir que la proportion de zones transparentes est inférieure à 50 % et préférentiellement inférieure à 10 %. Limiter la surface de zone gravée de la couche électrochimiquement active 6a permet de conserver une quantité importante de matériau actif dans le fonctionnement de la batterie ou du dispositif électrochrome.

En alternative, le collecteur de courant 5a peut présenter des zones avec des épaisseurs différentes afin de définir des premières régions et des deuxièmes régions dans le masque formé dans la première électrode 2a. En variante, le collecteur de courant 5a peut-être gravé afin de définir des zones couvertes et des zones non recouvertes à la surface du substrat de support 3a et ainsi définir des premières régions et des deuxièmes régions dans la première électrode 2a. La couche électrochimiquement active 6a vient en contact du substrat de support 3a dans les zones non recouvertes par le collecteur de courant 5a.

Dans une autre alternative de réalisation, la couche électrochimiquement active 6a et le collecteur de courant 5a présentent tous les deux des zones avec des épaisseurs différentes ce qui permet de définir des premières régions et des deuxièmes régions dans la première électrode 2a. Il est également possible de graver l'empilement formé par la couche électrochimiquement active 6a et le collecteur de courant 5a de manière à définir des zones couvertes et des zones non recouvertes à la surface du substrat de support 3a et ainsi définir des premières régions et des deuxièmes régions dans la première électrode 2a. L'électrolyte 1 vient en contact du substrat de support 3a dans les zones non recouvertes par la couche électrochimiquement active 6a et non recouvertes par le collecteur de courant 5a.

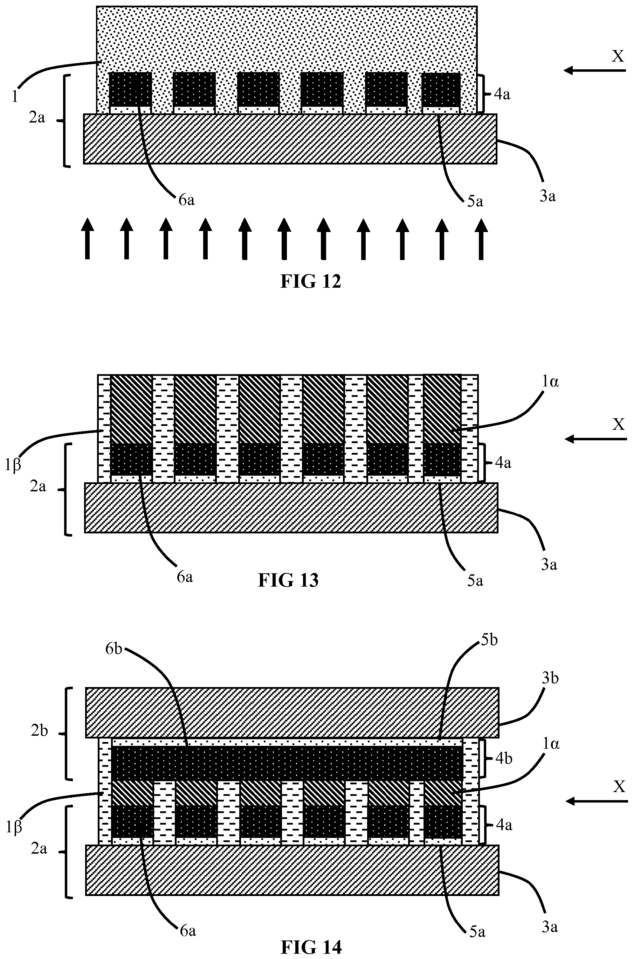

Dans le mode de réalisation illustré aux figures 12 à 15, la couche électrochimiquement active 6a et le collecteur de courant 5a définissent tous les deux des trous de manière à laisser passer le rayonnement incident et pour que toutes les zones du collecteur de courant 5a soit reliées entre elles et au même potentiel.

De manière particulièrement avantageuse, il est intéressant de prévoir que l'étape de polymérisation comporte une unique étape d'insolation qui est configurée pour former les première et deuxième zones 1α/1β. L'étape de polymérisation unique permet de définir rapidement et facilement la première et la deuxième zones 1α/1β dans la couche d'électrolyte. À la fin de l'étape de polymérisation, les première et deuxième zones 1α/1β sont présentes dans la couche d'électrolyte avec des premier et deuxième niveaux de réticulation différents. Ce mode de réalisation est obtenu, par exemple, par l'utilisation d'un masque d'insolation, présentant des zones à taux de transmission différents.

Dans un mode de réalisation particulier, la dose de rayonnement électromagnétique reçue par la première zone 1α est différente de la dose de rayonnement électromagnétique reçue par la deuxième zone 1β. La différence de dose peut provenir d'une différence dans les conditions opératoires d'insolation, par exemple une différence de puissance d'insolation entre les première et deuxième zones 1α/1β et/ou une différence de durée d'insolation entre les première et deuxième zones 1a/1β ce qui permet l'obtention de deux taux et/ou densités de réticulation différents.

Cette étape de polymérisation peut être réalisée avant de placer la deuxième électrode 2b en contact avec l'électrolyte 1.

L'électrolyte 1 est disposé sur la première électrode 2a. En fonction de sa viscosité, l'électrolyte 1 peut être localisé au moyen d'un bloqueur 8, ici sous la forme d'un anneau qui est en contact avec la première électrode 2a de manière à définir un réservoir qui est rempli par l'électrolyte 1. De manière particulièrement avantageuse, le réservoir est complètement rempli par l'électrolyte 1. L'électrolyte 1 est en contact avec la première électrode 2a. Le bloqueur 8, sous la forme d'un anneau, définit avantageusement une enceinte étanche en coopération avec la première électrode 2a et avec la deuxième électrode 2b après report de la deuxième électrode 2b.

Si l'électrolyte 1 est visqueux, le bloqueur 8 entourant l'électrolyte est avantageux mais il peut ne pas être utilisé. En variante, le bloqueur 8 peut être remplacé par de multiples parois latérales non jointives qui permettent de limiter l'écoulement de l'électrolyte 1 hors de la zone recherchée jusqu'à la polymérisation de l'électrolyte. Une fois la polymérisation effectuée, le bloqueur 8 peut être retiré. En alternative, le bloqueur 8 peut être conservé s'il permet de bloquer ou de retarder l'arrivée de polluants ou de molécules néfastes, par exemple l'oxygène et/ou l'eau.

Dans un mode de réalisation avantageux, des entretoises (non représentées) sont disposées sur la première électrode 2a. Ces entretoises permettent de définir la distance minimale qui sépare les deux électrodes 2a et 2b dans le dispositif électrochimique. Il est avantageux d'utiliser les entretoises pour servir de bloqueur 8 et localiser l'électrolyte 1 à la surface des électrodes 2a et 2b.

De manière avantageuse, l'entretoise est configurée pour que la distance minimale entre la première électrode 2a et la deuxième électrode 2b soit inférieure à 500 microns. Dans un mode de réalisation particulier où le dispositif électrochimique est une batterie ou un dispositif électrochrome, l'entretoise est configurée pour que la distance entre les deux couches électrochimiquement actives 6a et 6b soit inférieure à 50 microns. Cette précaution permet d'éviter un court-circuit entre les deux électrodes 2a et 2b tout tant assurant l'obtention d'une faible distance entre les électrodes et donc d'une faible résistance électrique interne.

Dans un mode de réalisation particulier, les différences de propriétés optiques de la première électrode 2a sont obtenues en réalisant une première électrode 2a qui utilise des matériaux différents et/ou des épaisseurs différentes de matériaux pour définir la première région et la deuxième région du masque interne.

Dans le mode de réalisation illustré à la figure 9, la région centrale de la première électrode 2a est plus épaisse et forme une région plus absorbante et donc moins transmissive. L'étape d'insolation vient donc définir une première zone 1α avec des premières caractéristiques de réticulation dans le prolongement de la zone centrale et une deuxième zone 1β avec des deuxièmes caractéristiques de réticulation autour de cette zone centrale. De manière avantageuse, la deuxième zone 1β entoure complètement la première zone 1α.

Bien que tous les modes de réalisation suggèrent une puissance uniforme de la source de rayonnement, il est possible d'utiliser tous ces modes de réalisation avec une source de rayonnement qui délivre au moins deux puissances différentes simultanément pour deux régions distinctes du dispositif électrochimique.

Tous les modes de réalisation sont également présentés avec un rayonnement qui présente une seule direction de propagation, c'est-à-dire un seul angle par rapport à la surface du dispositif électrochimique ou du premier empilement. En variante, il est avantageux d'utiliser différentes conditions d'insolation et notamment des conditions d'insolation avec des angles différents (entre le rayonnement incident et à la surface de l'électrode 2a) afin de former des première et/ou deuxième zones 1α/1β à forme complexe reliant la première électrode 2a avec la deuxième électrode 2b. Cela permet également de réduire le volume de l'une des deux zones par rapport au masque qui est défini par la première électrode 2a.

Le dispositif électrochimique peut être réalisé de différentes manières. Une première réalisation avantageuse peut être obtenue en décomposant le dispositif électrochimique en deux empilements distincts et en associant ces deux empilements par la suite.

Dans un mode de réalisation particulier, il est particulièrement avantageux de réaliser un premier empilement comprenant la première électrode 2a indépendamment d'un deuxième empilement comprenant la deuxième électrode 2b. Ces deux empilements sont ensuite assemblés pour former le dispositif électrochimique.

Le premier empilement peut-être formé simplement de la manière suivante. La première électrode 2a est fournie et l'électrolyte 1 est déposé sur la première électrode 2a. Si nécessaire le bloqueur 8 peut être utilisé pour confiner l'électrolyte 1.

Le deuxième empilement peut être formé simplement, de la manière suivante, en fournissant la deuxième électrode 2b.

L'étape de polymérisation est réalisée avant la mise en contact de la deuxième électrode 2b avec l'électrolyte 1.

La deuxième électrode 2b est mise en contact avec l'électrolyte liquide 1 qui vient séparer les deux électrodes 2a et 2b. Le dispositif électrochimique est formé.

Ce mode de réalisation peut être utilisé pour former un dispositif complexe tel qu'une batterie ou un dispositif électrochrome. La première électrode 2a est par exemple formée en fournissant un substrat de support 3a sur lequel est formé un premier collecteur de courant 5a. Il est ensuite possible de former une première couche électrochimiquement active 6a sur le premier collecteur de courant 5a.

Lors de la mise en contact, la première zone 1α relie la première couche électrochimiquement active 6a avec la deuxième couche électrochimiquement active 6b. La deuxième zone 1β relie le premier collecteur de courant 5a avec le deuxième collecteur de courant 5b et/ou le premier substrat de support 3a avec le deuxième substrat de support 3b. Il est particulièrement avantageux de prévoir que la première zone 1α possède une conductivité ionique supérieure à celle de la deuxième zone 1β. Il est également avantageux de prévoir que la deuxième zone 1β possède des performances mécaniques supérieures à celles de la première zone 1α.

Selon les modes de réalisation, les différentes couches formant la première électrode peuvent être déposées pleine plaque puis ensuite gravées. En alternative, les différentes couches peuvent être formées à travers un masque de manière à définir directement les motifs recherchés. Il est également possible de combiner ces deux techniques en fonction des couches à déposer. Comme précédemment, une fois la première électrode formée, l'électrolyte liquide 1 peut être déposé. Dans ce cas de figure, l'électrolyte est déposé en contact avec la couche électrochimiquement active. Là encore, un bloqueur 8 peut être utilisé.

La deuxième électrode 2b peut être formée de manière similaire à la première électrode 2a. La deuxième électrode 2b et plus particulièrement la deuxième couche électrochimiquement active 6b est mise en contact avec l'électrolyte liquide 1.

Si une partie de l'électrolyte est conservée sous forme liquide, ce dernier peut alors s'infiltrer facilement dans les tortuosités du matériau formant l'électrode ce qui n'est pas le cas avec un électrolyte solide. Cette solution est particulièrement avantageuse lors de la réalisation d'une batterie ou d'un dispositif électrochrome qui comporte un collecteur de courant 5a/5b surmonté par une couche électrochimiquement active 6a/6b.

Les figures 16 et 17 illustrent un autre mode de réalisation où les première et deuxième électrodes sont formées sur le même substrat de support 3. Les deux électrodes sont formées avant l'étape de polymérisation. Les matériaux utilisés sont avantageusement identiques à ceux présentés dans les modes de réalisation précédents. L'étape de polymérisation est configurée pour former la première zone 1α et la deuxième zone 1β. De manière avantageuse, l'étape de polymérisation est configurée pour former une première zone de polymérisation 1α au-dessus de la première électrode 2a et au-dessus de la deuxième électrode 2b. La première zone 1α se trouve au-dessus des électrodes selon un axe perpendiculaire à un plan qui contient les première et deuxième électrodes 2a et 2b. L'étape de polymérisation est configurée pour former une deuxième zone de polymérisation 1β entre la première électrode 2a et la deuxième électrode 2b. De manière préférentielle, la deuxième zone 1β présente une meilleure conductivité ionique que la première zone 1α ce qui permet d'améliorer le transit des ions entre les deux électrodes 2a et 2b. La tenue mécanique du dispositif électrochimique est assurée par les premières zones 1α.

Dans un mode de réalisation encore plus avantageux, l'espace situé entre les première et deuxième électrodes 2a et 2b comporte des deuxièmes et troisièmes zones de polymérisation 1β et 1Ω. La troisième zone 1Ω présente un troisième taux de réticulation qui est différent du premier taux de réticulation et/ou du deuxième taux de réticulation. La troisième zone 1Ω présente une troisième densité de réticulation qui est différente de la première densité de réticulation et/ou de la deuxième densité de réticulation. Les deuxième et troisième zones 1β et 1Ω présentent des performances mécaniques différentes afin d'éviter une fragilisation trop importante du dispositif électrochimique entre les deux électrodes 2a et 2b. Les deuxième et troisième zones 1β et 1Ω présentent, de préférence, une meilleure conduction ionique que la première zone 1α.

Dans un mode de réalisation avantageux, les première, deuxième et troisième zones sont réalisées au moyen d'un masque 7 qui comporte des première, deuxième et troisième régions 7a, 7b et 7c présentent des taux de transmissions différents.

Dans le mode de réalisation illustré aux figures 16 et 17, l'électrolyte est encapsulé par un capot, par exemple par le deuxième substrat de support (non représenté).

De manière avantageuse, la différence dans le taux de réticulation entre les première et deuxième zones et/ou la différence de densité de réticulation entre les première et deuxième zones sont configurées pour que les première et deuxième zones présentent une inhomogénéité structurelle qui est associée à une différence de comportement mécanique et/ou à une différence de comportement électrique, par exemple une différence de conduction ionique. A titre d'exemple, la différence de comportement mécanique et/ou la différence de comportement électrique est au moins égale à 5%, de préférence au moins égale à 10% et encore plus avantageusement au moins égale à 20%.

Dans la première zone de polymérisation et dans la deuxième zone de polymérisation, les caractéristiques mécaniques (par exemple le module de Young) et les caractéristiques électriques (par exemple la résistance électronique et/ou la conduction ionique) sont homogènes. Cette homogénéité peut être observée selon la direction perpendiculaire à la première face principale de l'électrolyte 1, c'est-à-dire selon la direction utilisée pour réaliser la polymérisation de l'électrolyte 1.

En revanche, selon la direction parallèle, à la première face principale de l'électrolyte 1, les caractéristiques mécaniques et/ou électriques sont différentes, c'est-à-dire moins homogènes entre une première zone et une deuxième zone adjacente.

## Revendications

1. Procédé de fabrication d'un dispositif électrochimique comportant les étapes suivantes :
- fournir une première électrode (2a),
- fournir une deuxième électrode (2b),
- fournir un électrolyte (1) isolant électroniquement et conducteur ioniquement, l'électrolyte (1) présentant un taux de réticulation initial et une densité de réticulation initiale, l'électrolyte (1) étant au moins en contact avec la première électrode (2a),
- réaliser une étape de polymérisation de l'électrolyte (1) de manière à définir au moins une première zone de polymérisation (1α) présentant un premier taux de réticulation et une première densité de réticulation et une deuxième zone de polymérisation (1β) présentant un deuxième taux de réticulation différent du premier taux de réticulation et/ou une deuxième densité de réticulation différente de la première densité de réticulation, les premier et deuxième taux de réticulation étant supérieur au taux de réticulation initial et les première et deuxième densités de réticulation étant supérieures à la densité de réticulation initiale.

2. Procédé de fabrication selon la revendication 1, **caractérisé en ce que** l'étape de polymérisation définit une alternance de premières zones de polymérisation (1α) et de deuxièmes zones de polymérisation (1β) selon une direction (X) parallèle à la première face principale de l'électrolyte (1).

3. Procédé de fabrication selon l'une des revendications 1 et 2, **caractérisé en ce que** l'étape de polymérisation est une étape de polymérisation par insolation avec au moins un rayonnement électromagnétique.

4. Procédé de fabrication selon la revendication 3, **caractérisé en ce qu'**il comporte une source de rayonnement électromagnétique configurée pour émettre une première puissance de rayonnement électromagnétique pour former la première zone de polymérisation (1α) et la deuxième zone de polymérisation (1β).

5. Procédé de fabrication selon la revendication 3, **caractérisé en ce qu'**il comporte une source de rayonnement électromagnétique configurée pour émettre simultanément une première puissance de rayonnement électromagnétique pour former la première zone de polymérisation (1α) et une deuxième puissance de rayonnement électromagnétique différente de la première puissance pour former la deuxième zone de polymérisation (1β).

6. Procédé de fabrication selon l'une quelconque des revendications 3 à 5, **caractérisé en ce que** l'étape de polymérisation comporte une étape d'insolation à travers un masque (7) présentant au moins deux régions présentant des taux de transmission différents audit au moins un rayonnement électromagnétique pour former lesdites au moins première et deuxième zones de polymérisation (1α, 1β).

7. Procédé de fabrication selon la revendication 6, **caractérisé en ce que** les au moins deux régions du masque (7) sont configurées pour laisser passer ledit au moins un rayonnement électromagnétique.

8. Procédé de fabrication selon l'une quelconque des revendications 4 à 7, **caractérisé en ce qu'**il comporte une unique étape d'insolation configurée pour former lesdites au moins première et deuxième zones de polymérisation (1α, 1'β).

9. Procédé de fabrication selon l'une quelconque des revendications 4 à 8, **caractérisé en ce que** la durée d'insolation par le rayonnement électromagnétique est identique pour former lesdites au moins première et deuxième zones de polymérisation (1α, 1β).

10. Procédé de fabrication selon l'une quelconque des revendications 4 à 8, **caractérisé en ce que** les durées d'insolation par le rayonnement électromagnétique sont différentes pour former lesdites au moins première et deuxième zones de polymérisation (1α, 1β).

11. Procédé de fabrication selon l'une quelconque des revendications précédentes, **caractérisé en ce que**, avant l'étape de polymérisation, l'électrolyte (1) est sous forme liquide et **en ce que** l'étape de polymérisation est configurée pour former au moins une des zones de polymérisation (1α, 1β) sous forme solide ou de gel et conserver l'autre des zones de polymérisation (1α, 1β) sous forme liquide.

12. Procédé de fabrication selon l'une quelconque des revendications 1 à 10, **caractérisé en ce que**, avant l'étape de polymérisation, l'électrolyte est sous forme liquide et **en ce que** l'étape de polymérisation est configurée pour former une première zone de polymérisation (1α) sous forme solide ou de gel et une deuxième zone de polymérisation (1β) sous forme solide ou de gel.

13. Procédé de fabrication selon l'une quelconque des revendications précédentes, **caractérisé en ce que** le dispositif électrochimique est une batterie ou un dispositif électrochrome et **en ce que** la première électrode (2a) comporte :
- un premier substrat de support (3a),
- un premier collecteur de courant (5a) recouvrant le premier substrat de support (3a),
- une première couche électrochimiquement active (6a) en contact électrique avec le premier collecteur de courant (5a), **en ce que** l'électrolyte (1) est en contact avec la première couche électrochimiquement active (6a) et **en ce que** la deuxième électrode (2b) comporte
- une deuxième couche électrochimiquement active (6b) séparée de la première couche électrochimiquement active (6a) par l'électrolyte (1),
- un deuxième collecteur de courant (5b) en contact avec la deuxième couche électrochimiquement active (6b), le deuxième collecteur de courant (5b) étant séparé du premier collecteur de courant (5a) par l'électrolyte (1),
- un deuxième substrat de support (3b).

14. Procédé de fabrication selon l'une quelconque des revendications précédentes, **caractérisé en ce que** la polymérisation de l'électrolyte (1) est réalisée au moyen d'un rayonnement ultraviolet.

15. Procédé de fabrication selon l'une quelconque des revendications précédentes, **caractérisé en ce que** la deuxième électrode (2b) est mise en contact avec l'électrolyte (1) avant l'étape de polymérisation.

16. Procédé de fabrication selon l'une quelconque des revendications 1 à 14, **caractérisé en ce que** la deuxième électrode (2b) est mise en contact avec l'électrolyte (1) après l'étape de polymérisation

17. Dispositif électrochimique comportant une première électrode (2a) et une deuxième électrode (2b) séparées par un électrolyte (1) électriquement isolant, **caractérisé en ce que** l'électrolyte (1) comporte une première zone de polymérisation (1α) présentant un premier taux de réticulation et une première densité de réticulation et une deuxième zone de polymérisation (1β) présentant un deuxième taux de réticulation différent du premier taux de réticulation et/ou une deuxième densité de réticulation différente de la première densité de réticulation, ladite première zone de polymérisation (1α) reliant la première électrode (2a) avec la deuxième électrode (2b) et ladite deuxième zone de polymérisation (1β) reliant la première électrode (2a) avec la deuxième électrode (2b) et **en ce que** la première zone de polymérisation (1α) et la deuxième zone de polymérisation (1β) sont formées par un électrolyte solide contenant un polymère, la première zone de polymérisation (1α) étant formée par un premier mélange ayant le premier taux de réticulation et la première densité de réticulation et la deuxième zone de polymérisation (1β) étant formée par le premier mélange ayant le deuxième taux de réticulation et la deuxième densité de réticulation.

## Patentansprüche

1. Verfahren zur Herstellung einer elektrochemischen Vorrichtung, die folgenden Schritte beinhaltend:
- Bereitstellung einer ersten Elektrode (2a),
- Bereitstellung einer zweiten Elektrode (2b),
- Bereitstellung eines elektronisch isolierenden und ionisch leitenden Elektrolyten (1), wobei der Elektrolyt (1) eine initiale Vernetzungsrate und eine initiale Vernetzungsdichte aufweist, wobei der Elektrolyt (1) mindestens mit der ersten Elektrode (2a) in Kontakt steht,
- Durchführung eines Schritts der Polymerisation des Elektrolyten (1), so dass mindestens eine erste Polymerisationszone (1α) definiert wird, die eine erste Vernetzungsrate und eine erste Vernetzungsdichte aufweist, und eine zweite Polymerisationszone (1β), die eine zweite Vernetzungsrate aufweist, die sich von der ersten Vernetzungsrate unterscheidet und/oder einer zweiten Vernetzungsdichte, die sich von der ersten Vernetzungsdichte unterscheidet, wobei die erste und zweite Vernetzungsrate größer sind als die initiale Vernetzungsrate und die erste und zweite Vernetzungsdichte größer sind als die initiale Vernetzungsdichte.

2. Herstellungsverfahren nach Anspruch 1, **dadurch gekennzeichnet, dass** der Polymerisationsschritt eine Alternation der ersten Polymerisationszone (1α) und der zweiten Polymerisationszone (1β) in einer Richtung (X) parallel zur ersten Hauptfläche des Elektrolyten (1) definiert.

3. Herstellungsverfahren nach einem der Ansprüche 1 und 2, **dadurch gekennzeichnet, dass** der Polymerisationsschritt ein Polymerisationsschritt durch Insolation mit mindestens einer elektromagnetischen Strahlung ist.

4. Herstellungsverfahren nach Anspruch 3, **dadurch gekennzeichnet, dass** es eine Quelle der elektromagnetischen Strahlung beinhaltet, die konfiguriert ist, um eine erste elektromagnetische Strahlungsleistung zu emittieren, um die erste Polymerisationszone (1α) und die zweite Polymerisationszone (1β) zu bilden.

5. Herstellungsverfahren nach Anspruch 3, **dadurch gekennzeichnet, dass** es eine Quelle der elektromagnetischen Strahlung beinhaltet, die konfiguriert ist, um gleichzeitig eine erste elektromagnetische Strahlungsleistung zu emittieren, um die erste Polymerisationszone (1α) zu bilden, und eine zweite elektromagnetische Strahlungsleistung, die sich von der ersten Leistung unterscheidet, um die zweite Polymerisationszone (1β) zu bilden.

6. Herstellungsverfahren nach einem der Ansprüche 3 bis 5, **dadurch gekennzeichnet, dass** der Polymerisationsschritt einen Schritt der Insolation durch eine Maske (7) hindurch beinhaltet, die mindestens zwei Bereiche aufweist, die Übertragungsraten aufweisen, die sich von der mindestens einen elektromagnetischen Strahlung unterscheiden, um die mindestens ersten und zweiten Polymerisationszonen (1α, 1β) zu bilden.

7. Herstellungsverfahren nach Anspruch 6, **dadurch gekennzeichnet, dass** die mindestens zwei Bereiche der Maske (7) konfiguriert sind, um die mindestens eine elektromagnetische Strahlung durchzulassen.

8. Herstellungsverfahren nach einem der Ansprüche 4 bis 7, **dadurch gekennzeichnet, dass** es einen einzigen Schritt der Insolation beinhaltet, der konfiguriert ist, um die mindestens erste und zweite Polymerisationszone (1α, 1β) zu bilden.

9. Herstellungsverfahren nach einem der Ansprüche 4 bis 8, **dadurch gekennzeichnet, dass** die Dauer der Insolation durch die elektromagnetische Strahlung zur Bildung der mindestens ersten und zweiten Polymerisationszone (1α, 1β) identisch ist.

10. Herstellungsverfahren nach einem der Ansprüche 4 bis 8, **dadurch gekennzeichnet, dass** die Dauer der Insolation durch die elektromagnetische Strahlung zur Bildung der mindestens ersten und zweiten Polymerisationszone (1α, 1β) unterschiedlich ist.

11. Herstellungsverfahren nach einem der vorhergehenden Ansprüche, **dadurch gekennzeichnet, dass**, vor dem Polymerisationsschritt, der Elektrolyt (1) in flüssiger Form vorliegt, und dass der Polymerisationsschritt konfiguriert ist, um mindestens eine der Polymerisationszonen (1α, 1β) in fester oder gelartiger Form zu bilden und die andere der Polymerisationszonen (1α, 1β) in flüssiger Form beizubehalten.

12. Herstellungsverfahren nach einem der Ansprüche 1 bis 10, **dadurch gekennzeichnet, dass**, vor dem Polymerisationsschritt, der Elektrolyt in flüssiger Form vorliegt, und dass der Polymerisationsschritt konfiguriert ist, um eine erste Polymerisationszone (1α) in fester oder gelartiger Form zu bilden und eine zweite Polymerisationszone (1β) in fester oder gelartiger Form.

13. Herstellungsverfahren nach einem der vorhergehenden Ansprüche, **dadurch gekennzeichnet, dass** die elektrochemische Vorrichtung eine Batterie oder eine elektrochrome Vorrichtung ist, und dass die erste Elektrode (2a) Folgendes beinhaltet:
- Ein erstes Trägersubstrat (3a),
- einen ersten Stromkollektor (5a), der das erste Trägersubstrat (3a) bedeckt,
- eine erste elektrochemisch aktive Schicht (6a) in elektrischem Kontakt mit dem ersten Stromkollektor (5a),
dass der Elektrolyt (1) in Kontakt steht mit der ersten elektrochemisch aktiven Schicht (6a) und dass die zweite Elektrode (2b) Folgendes beinhaltet:
- Eine zweite elektrochemisch aktive Schicht (6b), die von der ersten elektrochemisch aktiven Schicht (6a) durch den Elektrolyten (1) getrennt ist,
- einen zweiten Stromkollektor (5b), der in Kontakt mit der zweiten elektrochemisch aktiven Schicht (6b) steht, wobei der zweite Stromkollektor (5b) vom ersten Stromkollektor (5a) durch den Elektrolyten (1) getrennt ist,
- ein zweites Trägersubstrat (3b).

14. Herstellungsverfahren nach einem der vorhergehenden Ansprüche, **dadurch gekennzeichnet, dass** die Polymerisation des Elektrolyten (1) mittels einer ultravioletten Strahlung durchgeführt wird.

15. Herstellungsverfahren nach einem der vorhergehenden Ansprüche, **dadurch gekennzeichnet, dass** die zweite Elektrode (2b) vor dem Polymerisationsschritt mit dem Elektrolyten (1) in Kontakt gebracht wird.

16. Herstellungsverfahren nach einem der Ansprüche 1 bis 14, **dadurch gekennzeichnet, dass** die zweite Elektrode (2b) nach dem Polymerisationsschritt mit dem Elektrolyten (1) in Kontakt gebracht wird.

17. Elektrochemische Vorrichtung, die eine erste Elektrode (2a) beinhaltet und eine zweite Elektrode (2b), die durch einen elektrisch isolierenden Elektrolyten (1) getrennt sind, **dadurch gekennzeichnet, dass** der Elektrolyt (1) eine erste Polymerisationszone (1α) beinhaltet, die eine erste Vernetzungsrate und eine erste Vernetzungsdichte aufweist, und eine zweite Polymerisationszone (1β), die eine zweite Vernetzungsrate aufweist, die sich von der ersten Vernetzungsrate unterscheidet und/oder einer zweiten Vernetzungsdichte, die sich von der ersten Vernetzungsdichte unterscheidet, wobei die erste Polymerisationszone (1α) die erste Elektrode (2a) mit der zweiten Elektrode (2b) verbindet und die zweite Polymerisationszone (1β) die erste Elektrode (2a) mit der zweiten Elektrode (2b) verbindet, und dass die erste Polymerisationszone (1α) und die zweite Polymerisationszone (1β) durch einen Festelektrolyten gebildet sind, der ein Polymer umfasst, wobei die erste Polymerisationszone (1α) durch ein erstes Gemisch gebildet wird, das eine erste Vernetzungsrate und die erste Vernetzungsdichte hat, und die zweite Polymerisationszone (1β) durch das erste Gemisch gebildet wird, das die zweite Vernetzungsrate und die zweite Vernetzungsdichte hat.

## Claims

1. Method for fabricating an electrochemical device comprising the following steps:
- providing a first electrode (2a),
- providing a second electrode (2b),
- providing an electronically insulating and ionically conducting electrolyte (1), the electrolyte (1) presenting an initial degree of cross-linking and an initial cross-linking density, the electrolyte (1) being at least in contact with the first electrode (2a),
- performing a step of polymerising the electrolyte (1) so as to define at least a first polymerisation area (1α) presenting a first degree of cross-linking and a first cross-linking density and a second polymerisation area (1β) presenting a second degree of cross-linking different from the first degree of cross-linking and/or a second cross-linking density different from the first cross-linking density, the first and second degrees of cross-linking being higher than the initial degree of cross-linking and the first and second cross-linking densities being higher than the initial cross-linking density.

2. Method for fabricating according to claim 1, **characterized in that** the polymerisation step defines an alternation of first polymerisation areas (1α) and second polymerisation areas (1β) in a direction (X) parallel to the first main surface of the electrolyte (1).

3. Method for fabricating according to claim 1 or 2, **characterized in that** the polymerisation step is a polymerisation step by exposure by means of at least an electromagnetic radiation.

4. Method for fabricating according to claim 3, **characterized in that** it comprises an electromagnetic radiation source configured to emit a first electromagnetic radiation power to form the first polymerisation area (1α) and the second polymerisation area (1β).

5. Method for fabricating according to claim 3, **characterized in that** it comprises an electromagnetic radiation source configured to simultaneously emit a first electromagnetic radiation power to form the first polymerisation area (1α) and a second electromagnetic radiation power different from the first power to form the second polymerisation area (113).

6. Method for fabricating according to any of claims 3 to 5, **characterized in that** the polymerisation step comprises a step of exposure through a mask (7) having at least two regions presenting different transmission rates to said at least one electromagnetic radiation to form said at least first and second polymerisation areas (1α,1β).

7. Method for fabricating according to claim 6, **characterized in that** the at least two regions of the mask (7) are configured to allow said at least one electromagnetic radiation to pass.

8. Method for fabricating according to any of claims 4 to 7, **characterized in that** it comprises a single exposure step configured to form said at least first and second polymerisation areas (1α,1β).

9. Method for fabricating according to any of claims 4 to 8, **characterized in that** the time of exposure to the electromagnetic radiation is identical to form said at least first and second polymerisation areas (1α,1β).

10. Method for fabricating according to any of claims 4 to 8, **characterized in that** the times of exposure to the electromagnetic radiation are different to form said at least first and second polymerisation areas (1α,1β).

11. Method for fabricating according to any of the preceding claims, **characterized in that**, before the polymerisation step, the electrolyte (1) is in liquid form and **in that** the polymerisation step is configured to form at least one of the polymerisation areas (1α, 1β) in solid or gel form and to keep the other of the polymerisation areas (1α,1β) in liquid form.

12. Method for fabricating according to any of claims 1 to 10, **characterized in that**, before the polymerisation step, the electrolyte is in liquid form and the polymerisation step is configured to form a first polymerisation area (1α) in solid or gel form and a second polymerisation area (1β) in solid or gel form.

13. Method for fabricating according to any of the preceding claims, **characterized in that** the electrochemical device is a battery or an electrochrome device and **in that** the first electrode (2a) comprises:
- a first support substrate (3a),
- a first current collector (5a) covering the first support substrate (3a),
- a first electrochemically active layer (6a) in electric contact with the first current collector (5a),
**in that** the electrolyte (1) is in contact with the first electrochemically active layer (6a) and **in that** the second electrode (2b) comprises
- a second electrochemically active layer (6b) separated from the first electrochemically active layer (6a) by the electrolyte (1),
- a second current collector (5b) in contact with the second electrochemically active layer (6b), the second current collector (5b) being separated from the first current collector (5a) by the electrolyte (1),
- a second support substrate (3b).

14. Method for fabricating according to any of the preceding claims, **characterized in that** the polymerisation of the electrolyte (1) is performed by means of an ultraviolet radiation.

15. Method for fabricating according to any of the preceding claims, **characterized in that** the second electrode (2b) is placed in contact with the electrolyte (1) before the polymerisation step.

16. Method for fabricating according to any of claims 1 to 14, **characterized in that** the second electrode (2b) is placed in contact with the electrolyte (1) after the polymerisation step.

17. Electrochemical device comprising a first electrode (2a) and a second electrode (2b) separated by an electrically insulating electrolyte (1), **characterized in that** the electrolyte (1) comprises a first polymerisation area (1α) presenting a first degree of cross-linking and a first cross-linking density and a second polymerisation area (1β) presenting a second degree of cross-linking different from the first degree of cross-linking and/or a second cross-linking density different from the first cross-linking density, said first polymerisation area (1α) connecting the first electrode (2a) with the second electrode (2b) and said second polymerisation area (1β) connecting the first electrode (2a) with the second electrode (2b) and **in that** the first polymerisation area (1α) and second polymerisation area (1β) are formed by a solid electrolyte containing a polymer, the first polymerisation area (1α) being formed by a first mixture having the first degree of cross-linking and the first cross-linking density and the second polymerisation area (1β) being formed by the first mixture having the second degree of cross-linking and the second cross-linking density.
